# EUROPEAN PATENT APPLICATION

(11) **EP 4 675 018 A1**
(43) Date of publication of application: **07.01.2026**
(21) Application number: 24784631.4
(22) Date of filing: 26.02.2024
(51) Int. Cl.: C30B 29/36

(54) **CRUCIBLE AND METHOD FOR MANUFACTURING SAME**

(30) Priority: 06.04.2023 JP 2023061897
(71) Applicant: Sec Carbon, Ltd., Amagasaki-shi, Hyogo 661-0976 (JP)
(72) Inventor: YAMAGUCHI, Tomoki, Amagasaki-shi, Hyogo 661-0976 (JP); NISHIKIORI, Tokujiro, Amagasaki-shi, Hyogo 661-0976 (JP); SHIOMI, Hiromu, Amagasaki-shi, Hyogo 661-0976 (JP); WATANABE, Masahide, Amagasaki-shi, Hyogo 661-0976 (JP); ODAGAKI, Manabu, Amagasaki-shi, Hyogo 661-0976 (JP); SONE, Shinnosuke, Amagasaki-shi, Hyogo 661-0976 (JP)
(74) Representative: J A Kemp LLP
(86) International application number: PCT/JP2024/006749
(87) International publication number: WO 2024/209832

(57) **Abstract**

A crucible with higher growth rate of SiC single crystals and a method of manufacturing the same are provided. A crucible 10 is a crucible to be used to manufacture an SiC single crystal by the sublimation method, including: a bottom 120; a side wall 122 provided to extend upward from a peripheral edge of the bottom 120; and a lid 16 placed over the top of the side wall 122. The bottom 120, side wall 122, and lid 16 are formed from graphite. The crucible 10 has a vertical thermal conductivity VT along a vertical direction in which the side wall 122 extends, and a lateral thermal conductivity LT along a lateral direction perpendicular to the vertical direction. The vertical thermal conductivity VT is higher than the lateral thermal conductivity LT.

## Description

### TECHNICAL FIELD

The present disclosure relates to a crucible and a method of manufacturing the same, and, more particularly, to a crucible to be used to manufacture an SiC (silicon carbide) single crystal by the sublimation method and a method of manufacturing the same.

### BACKGROUND ART

JP 2010-126375 A (Patent Document 1), JP 2013-252998 A (Patent Document 2), JP 2018-58711 A (Patent Document 3), JP 2020-26367 A (Patent Document 4), JP 2020-111481 A (Patent Document 5), and JP 2021-70600 A (Patent Document 6) each disclose a crucible to be used to manufacture an SiC single crystal by the sublimation method. Each of these crucibles is made of graphite.

JP 2021-84826 A (Patent Document 7) discloses a heat-resistant member to be used in a crucible. This heat-resistant member includes a base material made of isotropic graphite and a single- or multi-layer coating formed over the entire surface of the base material or over part thereof. Isotropic graphite is a graphite material obtained by shaping a material by applying forces of the same magnitude from all directions by the cold isostatic press (CIP) method, followed by carbonization, densification, graphitization and processing, and is a polycrystalline material where each grain includes an aggregate of graphite crystallites in various orientations.

### PRIOR ART DOCUMENTS

### PATENT DOCUMENTS

Patent Document 1: JP 2010-126375 A
Patent Document 2: JP 2013-252998 A
Patent Document 3: JP 2018-58711 A
Patent Document 4: JP 2020-26367 A
Patent Document 5: JP 2020-111481 A
Patent Document 6: JP 2021-70600 A
Patent Document 7: JP 2021-84826 A

### SUMMARY OF THE INVENTION

### PROBLEMS TO BE SOLVED BY THE INVENTION

Reference Documents 1 to 6, all of which disclose that a crucible is made of graphite, do not explicitly describe manufacturing methods, physical properties, or other information. Reference Document 7 teaches that a crucible made of graphite is produced by the CIP method and is isotropic. Thus, a crucible typically used to grow an SiC single crystal by the sublimation method is typically provided by CIP forming, where a material widely used is round masses of coke (a graphite material made from round masses of coke as its material and provided by CIP forming will be hereinafter referred to as "CIP material", and a crucible fabricated using a CIP material will be referred to as "CIP-material crucible"). Meanwhile, a crucible that is used to produce an SiC single crystal is naturally required to provide a high growth rate of SiC single crystals. However, no documents have been found that discuss the relationship between a crucible made of a material other than a CIP material and the growth rate of SiC single crystals.

An object of the present disclosure is to provide a crucible with a higher growth rate of SiC single crystals than conventional CIP-material crucibles, and a method of manufacturing such a crucible.

### MEANS FOR SOLVING THE PROBLEMS

A crucible according to the present disclosure is a crucible to be used to manufacture an SiC single crystal by a sublimation method, including: a bottom; a side wall provided to extend upward from a peripheral edge of the bottom; and a lid placed over a top of the side wall. The bottom, the side wall, and the lid are formed from a graphite. The crucible has a vertical thermal conductivity along a vertical direction in which the side wall extends, and a lateral thermal conductivity along a lateral direction perpendicular to the vertical direction. The vertical thermal conductivity is higher than the lateral thermal conductivity.

### BRIEF DESCRIPTION OF THE DRAWINGS

[FIG. 1] FIG. 1 is a cross-sectional view of a crucible according to Embodiment 1, illustrating its construction.
[FIG. 2] FIG. 2 is a cross-sectional view illustrating a method of manufacturing the crucible shown in FIG. 1 through extrusion molding.
[FIG. 3] FIG. 3 is a perspective view of a piece of coke.
[FIG. 4] FIG. 4 is a cross-sectional view of a crucible, illustrating a method of manufacturing an SiC single crystal using it by the sublimation method.
[FIG. 5] FIG. 5 is a cross-sectional view of a crucible made of an CIP material (hereinafter referred to as "CIP-material crucible"), illustrating a method of manufacturing an SiC single crystal using it by the sublimation method.
[FIG. 6] FIG. 6 is a cross-sectional view of a crucible made of an extruded material (hereinafter referred to as "extruded-material crucible"), illustrating a method of manufacturing an SiC single crystal using it by the sublimation method.
[FIG. 7] FIG. 7 is a graph showing the relationship between the temperature of the top surface of a crucible and the ratio of the sublimation rate in an extruded-material crucible to that in a CIP-material crucible.
[FIG. 8] FIG. 8 is a graph showing the relationship between the temperature of the top surface of a crucible and the ratio of the growth rate in an extruded-material crucible to that in a CIP-material crucible.
[FIG. 9] FIG. 9 is a graph showing the temperature of the top surface of a crucible, on the one hand, and yield, on the other.
[FIG. 10] FIG. 10 is a graph showing the temperature of the top surface of a crucible, on the one hand, and seed ratio, on the other.

### EMBODIMENTS FOR CARRYING OUT THE INVENTION

### <Summary of Embodiments>

A crucible according to the present embodiment is a crucible to be used to manufacture an SiC single crystal by a sublimation method, including: a bottom formed from a graphite; a side wall provided to extend upward from a peripheral edge of the bottom and formed from a graphite; and a lid placed over a top of the side wall. The crucible has a vertical thermal conductivity along a vertical direction in which the side wall extends, and a lateral thermal conductivity along a lateral direction perpendicular to the vertical direction. The vertical thermal conductivity is higher than the lateral thermal conductivity.

In the crucible according to the present embodiment, the vertical thermal conductivity of the graphite is higher than its lateral thermal conductivity; thus, when an SiC single crystal is produced using this crucible, heat removal in the vertical direction of the crucible is promoted relative to that in the lateral direction, thereby increasing the growth rate of an SiC single crystal.

The ratio of the vertical thermal conductivity to the lateral thermal conductivity may be not lower than 1.04. In such implementations, the vertical thermal conductivity will be sufficiently higher than the lateral thermal conductivity compared with that of a graphite made of a CIP material.

The vertical thermal conductivity may be not lower than 100 W/m·K. In such implementations, the thermal conductivity will be sufficiently higher than that of a graphite produced from a material including round masses of coke.

The side wall may have a thickness not smaller than 10 mm. In such implementations, the amount of heat transported per unit time will be increased.

The graphite may be formed from an extruded material. In such implementations, the graphite is likely to be anisotropic with respect to thermal conductivity.

A method of manufacturing a crucible according to the present embodiment includes: preparing a material; pulverizing the material; kneading the pulverized material together with a binder pitch to prepare a kneaded material; extruding the kneaded material to form a columnar body; heating the columnar body for graphitization; and processing the graphitized columnar body to form the crucible. The crucible includes: a bottom formed from a graphite; and a side wall provided to extend upward from a peripheral edge of the bottom and formed from a graphite. A vertical direction in which the side wall extends is identical with a direction in which the kneaded material is extruded.

The method of manufacturing a crucible according to the present embodiment will enable manufacturing a crucible made of a graphite with a vertical thermal conductivity higher than its lateral thermal conductivity.

The material may include pieces of coke with an aspect ratio of a large diameter to a small diameter not lower than 1.1. In such implementations, the graphite is likely to be anisotropic with respect to thermal conductivity.

Starting from the crucible manufactured by any one of the above methods, the crucible may have a vertical thermal conductivity along a vertical direction in which the side wall extends and a lateral thermal conductivity along a lateral direction perpendicular to the vertical direction. The vertical thermal conductivity may be higher than the lateral thermal conductivity. When an SiC single crystal is produced using this crucible, the growth rate of SiC single crystals will be higher.

### <Details of Embodiments>

Now, a crucible and a manufacture method according to embodiments will be described in detail with reference to the drawings. In the drawings, the same or corresponding portions will be labeled with the same characters, and their description will not be repeated.

### <Embodiment 1>

### <Construction of Crucible>

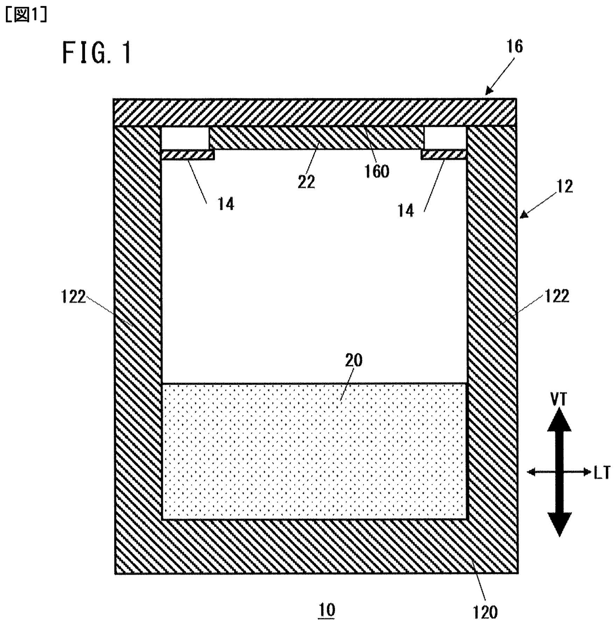

Referring to FIG. 1, a crucible 10 according to Embodiment 1 is a crucible to be used to manufacture an SiC single crystal by the sublimation method, including a container 12 and a lid 16. Both the container 12 and lid 16 are made of graphite.

The container 12 is to be loaded with an SiC source material 20 in the form of powder. The container 12 includes a bottom 120 and a side wall 122 provided to extend upward from the peripheral edge of the bottom 120. The lid 16 is provided on top of the container 12 and includes a lower surface 160 that allows an SiC seed crystal 22 to be mounted thereon. A support 14 is provided between the container 12 and lid 16 to support the SiC seed crystal 22.

The SiC seed crystal 22 may be placed in close contact with the lower surface 160. One way to achieve this is that, for example, the crucible 10 further includes the support 14. The upper surface of the support 14 supports the SiC seed crystal 22 from below and, in addition, may press the SiC seed crystal 22 upward. The support 14 is not limited to any cross-sectional shape, and may have the shape of a rectangle, a right rectangle, or a trapezoid, for example. Another way is to apply, to the upper face of the SiC seed crystal 22 and/or the lower surface 160, an adhesive that can keep holding them together even near the growth temperature, thus bonding the SiC seed crystal 22. Examples of adhesives include carbon adhesives, thermosetting resins, phenol resins, and polyimides. Alternatively, the back face of the SiC seed crystal 22 may be protected by such an adhesive or a carbon film or metal carbide film and the periphery of the SiC seed crystal 22 may be mechanically held and not in close contact with the lower surface 160 in order to reduce stress.

The crucible 10 in FIG. 1 expands during growth and contracts during cooling; as such, if there is a large difference in circumferential thermal expansion between the container 12 and lid 16, sublimated gas may leak or the crucible 10 may break. In view of this, it is preferable that the container 12 and lid 16 are made of similar materials to reduce their difference in circumferential thermal expansion.

The crucible 10 has a vertical thermal conductivity VT along a vertical direction in which the side wall 122 extends, and a lateral thermal conductivity LT along a lateral direction perpendicular to the vertical direction. The vertical thermal conductivity VT is higher than the lateral thermal conductivity LT.

In the crucible 10, the vertical thermal conductivity VT of the graphite is higher than its lateral thermal conductivity LT such that, as described in detail further below, the sublimation rate of the SiC source material is higher than in a crucible with vertical and lateral thermal conductivities VT and LT that are equal to each other. This increases the growth rate of an SiC single crystal.

The ratio of the vertical thermal conductivity VT to the lateral thermal conductivity LT (hereinafter referred to as "thermal conductivity ratio VT/LT") is to be not lower than 1.04. Generally, a graphite made of a CIP (cold isostatic press) material is isotropic with respect to thermal conductivity; even in an anisotropic graphite, the thermal conductivity ratio VT/LT is lower than 1.01. On the other hand, a graphite made of an extruded material is anisotropic with respect to thermal conductivity, where the thermal conductivity ratio VT/LT is not lower than 1.01. If the thermal conductivity ratio VT/LT is not lower than 1.04, the sublimation rate of an SiC source material is higher than in a crucible with a thermal conductivity ratio VT/LT not higher than 1.01. This provides sufficiently high growth rate of an SiC single crystal. A preferable lower limit of the thermal conductivity ratio VT/LT may be 1.05, 1.06, 1.07, 1.08, 1.09, or 1.10, for example. Although not limiting, an upper limit of the thermal conductivity ratio VT/LT may be 2.0, 1.9, 1.8, 1.7, 1.6, 1.5, 1.4, 1.3, or 1.2, for example.

The thermal conductivity is to be not lower than 100W/m·K. A preferable lower limit of thermal conductivity may be 110 W/m·K, 120 W/m·K, 130 W/m·K, 140 W/m·K, 150 W/m·K, 160 W/m·K, 170 W/m·K, 180 W/m·K, 190 W/m·K, or 200 W/m·K, for example. The thermal conductivity of a graphite produced from a material including elongated needle-shaped pieces of coke is higher than the thermal conductivity of a graphite produced from a material including round masses of coke.

To specify representative values of physical properties, the vertical thermal conductivity VT is to be 150 to 240 W/m·K, the lateral thermal conductivity LT is to be 140 to 180 W/m·K, and the thermal conductivity ratio VT/LT is to be not lower than 1.04.

The side wall 122 has a thickness of 2 to 50 mm. If the thickness of the side wall 122 is too small, this hampers heat supply from the side wall 122 to the source material 20 such that the effect of increasing the sublimation rate is not produced. Although not limiting, a preferable lower limit of the thickness of the side wall 122 may be 3 mm, 5 mm, 10 mm, 15 mm, or 20 mm, for example. If the thickness of the side wall 122 is too large, the loading capacity for the source material 20 decreases relative to the volume of the crucible 10 such that either the thickness of a crystal that can be grown is limited or the size of the crucible 10 is increased. Although not limiting, an upper limit of the thickness of the side wall 122 may be 40 mm, 35 mm, 30 mm, or 25 mm, for example.

### <Method of Manufacturing Crucible>

Next, a method of manufacturing the crucible 10 will be described.

A method of manufacturing the crucible 10 includes: the step of preparing a material; the step of pulverizing and mixing the material; the step of kneading the pulverized material together with a binder pitch to prepare a kneaded material; the step of cooling the kneaded material to a temperature at which it is likely to exhibit thermoplasticity; the step of extruding the thermoplastic kneaded material through a nozzle tapered at a predetermined rate to form a columnar body; the step of heating the columnar body for graphitization; and the step of processing the graphitized columnar body to form a crucible.

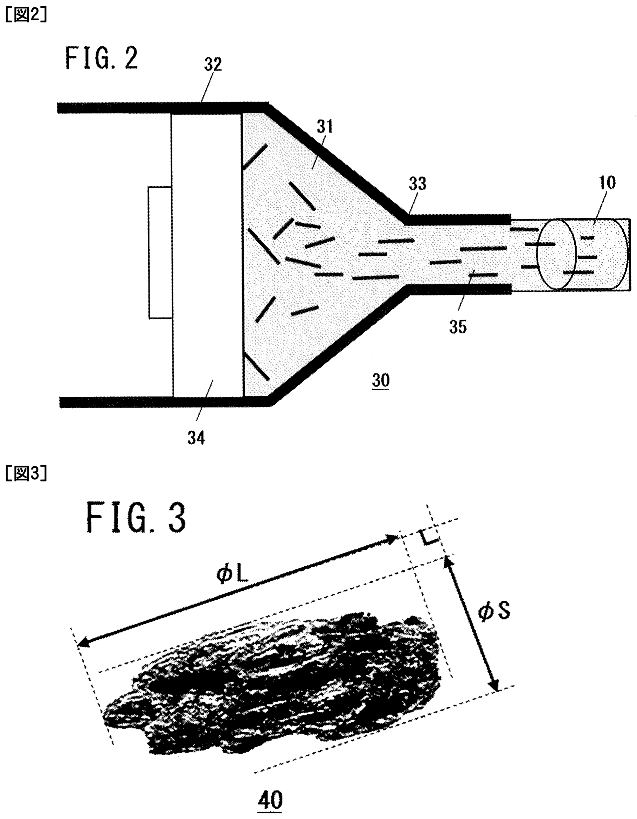

FIG. 2 is a schematic view of extrusion molding equipment 30. Referring to FIG. 2, the extrusion molding equipment 30 includes a container 32 that contains a kneaded material 31, a die 33 that squeezes the kneaded material 31, and a pusher 34 that pushes the kneaded material 31 contained in the container 32 toward the die 33. When inside the container 32 and die 33, the kneaded material 31 is adjusted to a temperature that provides liquidity and, after being discharged from the die 33, to a temperature that significantly reduces liquidity such that, while the kneaded material is being squeezed by the die 33, the material contained therein receives resistance so as to be easily oriented in a direction parallel to extrusion.

The extrusion molding equipment 30 performs the step of extruding the kneaded material 31 to form a columnar body 35. After this step, the columnar body 35 is carbonized, densified, graphitized, and processed to form the crucible 10, where the vertical direction in which the side wall 122 of the crucible 10 extends is identical with the direction in which the kneaded material 31 is extruded.

The material includes pieces of coke 40, as shown in FIG. 3. A piece of coke 40 has the shape of an elongated needle. In other words, the piece of coke 40 has a large diameter φL, which is its largest outer diameter, and a small diameter φS, which is perpendicular to the large diameter φL.

Before the step of pulverizing the pieces of coke 40, the aspect ratio of the large diameter φL to the small diameter φS of a piece of coke 40 (=φL_{/}φS) is to be not lower than 1.1. Although not limiting, a preferable lower limit of the aspect ratio may be 1.2, 1.3, or 1.4, for example. Although not limiting, an upper limit of the aspect ratio may be 3.0, 2.5, or 2.0, for example.

Additionally, or alternatively, after the step of pulverizing the pieces of coke 40 and before the step of kneading them, the aspect ratio of a piece of coke 40 is to be not lower than 1.5. Although not limiting, a preferable lower limit of the aspect ratio may be 1.6, 1.7, or 1.8, for example. Although not limiting, an upper limit of the aspect ratio may be 7.0, 6.5, or 6.0, for example.

In implementations where the material includes elongated needle-shaped pieces of coke 40, the kneaded material 31 is extruded while the major axis of the elongated pieces of the material after pulverization is aligned with the direction of extrusion, as shown in FIG. 2, such that the graphite constituting the crucible 10 is likely to be anisotropic with respect to thermal conductivity. Specifically, the vertical thermal conductivity VT of the graphite is sufficiently higher than its lateral thermal conductivity LT. The higher the aspect ratio, the higher the thermal conductivity ratio VT/LT. Further, there is a tendency that the smaller the grain size (e.g., average diameter or median diameter) of the pieces of coke 40, the higher the aspect ratio, increasing the thermal conductivity ratio VT/LT.

In addition to the elongated needle-shaped pieces of coke 40, the material may include round masses of coke. In such implementations, the proportions of coke in the shape of elongated needles 40 and coke in the shape of round masses that are mixed together may be varied to adjust the thermal conductivity ratio VT/LT. For the same grain diameter, elongated needle-shaped pieces of coke have a better developed hexagonal net structure than round masses of coke and can be graphitized more easily; thus, the higher the proportion of coke in the shape of elongated needles 40 compared with the proportion of coke in the shape of round masses, the higher the thermal conductive. Further, for the same grain diameter, elongated needle-shaped pieces of coke have a higher aspect ratio and a stronger orientation than round masses of coke, and thus are easily aligned in a direction parallel to the advance of the pusher 34 during molding; thus, the higher the proportion of coke in the shape of elongated needles 40 compared with the proportion of coke in the shape of round masses, the higher the thermal conductivity ratio VT/LT.

In the crucible 10 thus produced, the graphite has a vertical thermal conductivity VT in the vertical direction in which the side wall 122 extends and a lateral thermal conductivity LT in the lateral direction perpendicular to the vertical direction. The vertical thermal conductivity VT is higher than the lateral thermal conductivity LT.

### <Method of Using Crucible>

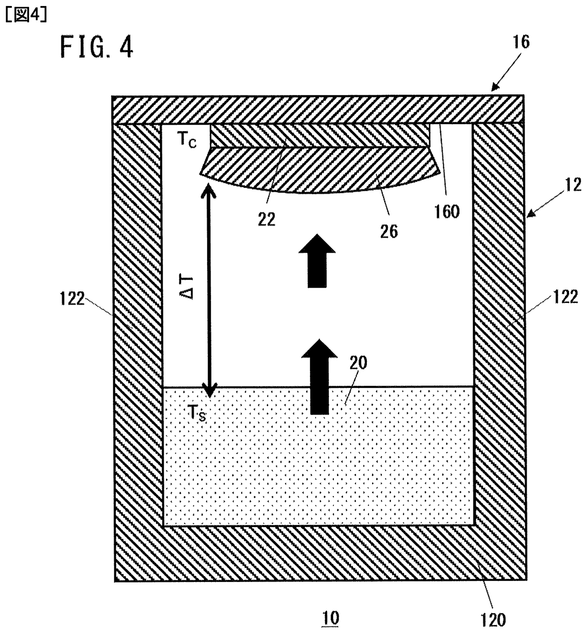

Next, an exemplary method of manufacturing an SiC single crystal using the crucible 10 by the sublimation method will be described. Referring to FIG. 4, the growth of an SiC single crystal 26 uses the sublimation-recrystallization method (i.e., Lely method). The sublimation-recrystallization method involves creating a temperature gradient between the lower and upper portions of the crucible 10, heating the loaded SiC source material 20 at high temperature (not lower than 2000 °C) for sublimation, and causing the material to recrystallize on the SiC seed crystal 22 placed on the back surface of the lid 16 to grow the SiC single crystal 26. When the temperature of the lower portion of the crucible 10 (i.e., source material 20) is represented by *Ts* and the temperature of the upper portion (i.e., SiC seed crystal 22) is represented by *Tc*, then, *Ts> Tc* and there is a temperature difference *ΔT=Ts-Tc.* As the temperature of the source material *Ts* increases, the sublimation rate of the source material 20 increases. As the crystallization temperature *Tc* decreases, the growth rate of the SiC single crystal 26 increases.

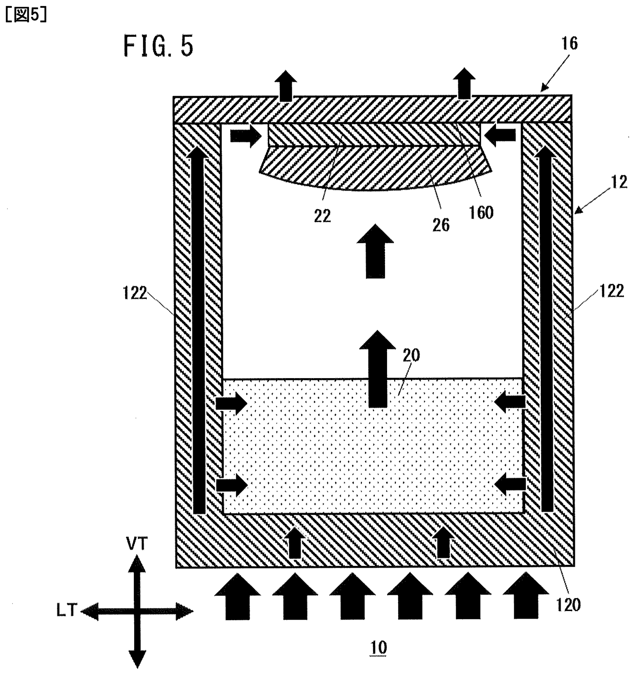

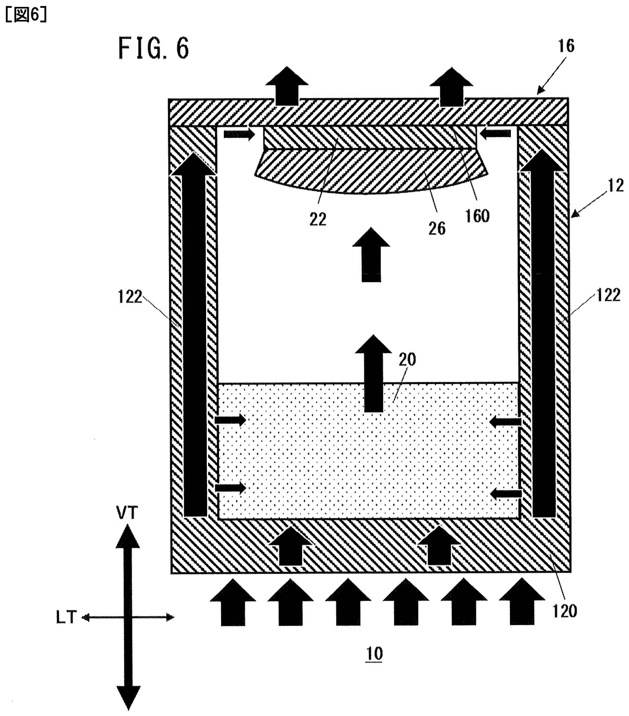

FIG. 5 illustrates a method of manufacturing an SiC single crystal 26 using a CIP-material crucible 10 by the sublimation method. FIG. 6 illustrates a method of manufacturing an SiC single crystal 26 using the extruded-material crucible 10 by the sublimation method. In FIGS. 5 and 6, the width of an arrow is proportional to the amount of heat transported per unit time.

In addition to the bottom 120 of the crucible 10, the supply of heat to the SiC source material 20 via the side wall 122 of the crucible 10 sufficiently increases compared with that in the crucible 10 made of a CIP material, thus promoting sublimation of the SiC source material 20.

The vertical thermal conductivity VT being higher than the lateral thermal conductivity LT is advantageous also with respect to heat removal through the top surface of the crucible 10, as it smooths upward heat removal through and from the lid 16 made of graphite in contact with the back face of the seed crystal 22, which lowers the temperature of the crystal growth face, resulting in a higher degree of supersaturation of nearby sublimated gas, increasing the driving force for recrystallization.

Further, heat that has passed through the side wall 122 of the crucible 10 and reached the lid 16 of the crucible 10 increases the temperature of peripheral portions of the lid 16 of the crucible 10, on which, otherwise, polycrystalline material could easily grow; thus, the ratio of polycrystalline material to single crystal growing on the seed crystal 22 decreases, thereby promoting growth of the single crystal.

The lateral thermal conductivity LT being not as high as the vertical thermal conductivity VT prevents heat that has warmed locations where polycrystalline material would otherwise grow from reaching the location where the single crystal is growing, which has the effect of maintaining low temperature of the crystal growth face.

The above effects combine to achieve a high growth rate of an SiC single crystal.

Furthermore, a crucible with a relatively low lateral thermal conductivity LT restricts sideway exchange of heat with the outside of the crucible compared with a crucible with equivalently high thermal conductivities in all directions of the crucible 10. Thus, a vertical thermal conductivity VT that is higher than the lateral thermal conductivity LT not only promotes uniform heating within the area where the crystal grows (i.e., small temperature gradient), but also has secondary effects that will lead to a reduction in the thermal energy needed for heating.

### EXAMPLES

In the examples described below, material-related differences between an extruded material and a CIP material during SiC single-crystal growth by the sublimation method was investigated; for this purpose, extruded-material crucibles (where the top-bottom direction of the crucible is identical with the direction of extrusion) and a CIP-material crucible were prepared.

To provide an extruded material, elongated needle-shaped pieces of coke with an aspect ratio before pulverization not lower than 1.1 and with an aspect ratio after pulverization not lower than 1.5 were prepared as a material, to which a binder pitch was added and kneaded together to prepare a kneaded material. This kneaded material was extruded by extrusion-molding equipment to form a columnar body, which was baked to provide a carbonaceous material. During this, baking and pitch impregnation were repeated multiple times for densification. The columnar body was heated in an AG furnace for graphitization and, thereafter, processed in such a manner that the top-bottom direction of the crucible was parallel to the extrusion, thereby fabricating an extruded-material crucible.

A CIP-material crucible to serve as a comparison was prepared, which had been fabricated by forming round masses of coke, as a main material, through CIP forming and then performing the same subsequent steps (IG-12 from Toyo Tanso Co., Ltd.). The crucible used had a vertical thermal conductivity VT of 100 W/m·K, a lateral thermal conductivity LT of 100 W/m·K, and a thermal conductivity ratio VT/LT of 1.00.

All the crucibles had the same shape. The thicknesses of the side walls of the extruded-material crucibles were 10 mm, 15 mm, and 20 mm, respectively. The thickness of the side wall of the CIP-material crucible was 10 mm.

Each crucible was loaded with a 2 to 3 kg SiC source material load and, with an SiC seed crystal held on the lower surface of the lid of the crucible, under reduced pressure, sufficient single crystal growth for a predetermined period of time was performed for enabling the weight measurement discussed further below, for example, where the temperature of the heat source was kept at 2300 to 2400 °C.

After completion of each crystal growth test, the change in the weight of the loaded SiC source material was measured, which was divided by the growth time to calculate the sublimation rate per unit time.

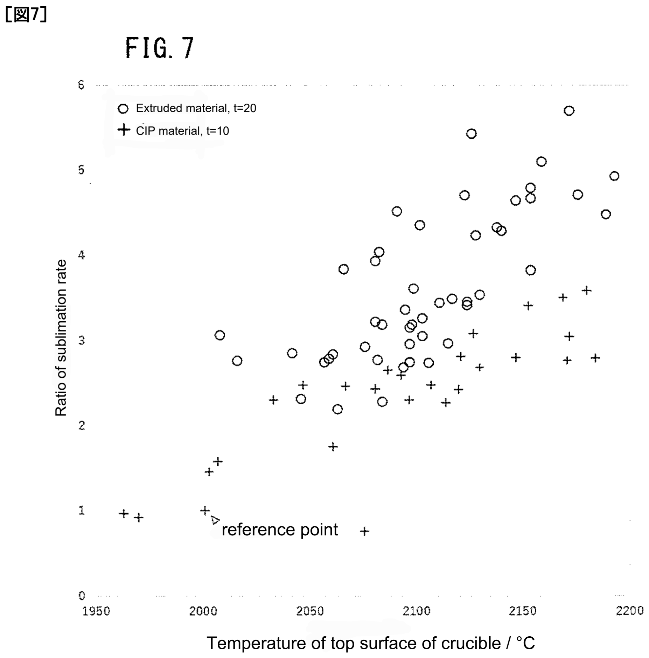

FIG. 7 shows the relationship between the temperature of the top surface of a crucible measured by a radiation thermometer early in the growth of each crystal, on the one hand, and the associated sublimation rate, on the other. Simulations have shown that the temperature of the top surface of a crucible is generally proportional with the temperature of the crystal growth surface and SiC source material, although it depends on the heat resistance of the crucible itself. To facilitate discussion of the effects of the material of a crucible and the thickness of the side wall of the crucible, the measurements were limited to cases where the heat source was located below the crucible. Further, since the temperature conditions of the heat source, the positioning of the heat insulator around the crucible and other conditions are slightly different for each experiment, the graph shows the ratio of an obtained sublimation rate to the result for the CIP-material crucible for a top-surface temperature of about 2000 °C (shown in the graph).

Tendencies in FIG. 7 demonstrate that, across the entire range of temperature of the top surface of a crucible from about 2000 to 2200 °C, the use of an extruded-material crucible enhances the sublimation rate over the CIP-material crucible by about 30 %. This is a result of an extruded-material crucible, which had better heat conductivity along the height direction of the crucible than the CIP-material crucible, providing smoother supply of heat to the source material via the bottom and side surfaces of the crucible. It can also be assumed that upward heat removal from the location of crystal growth through and from the lid of the crucible was promoted, increasing the amount of sublimated gas consumed by recrystallization, thereby maintaining such high sublimation rates as mentioned above.

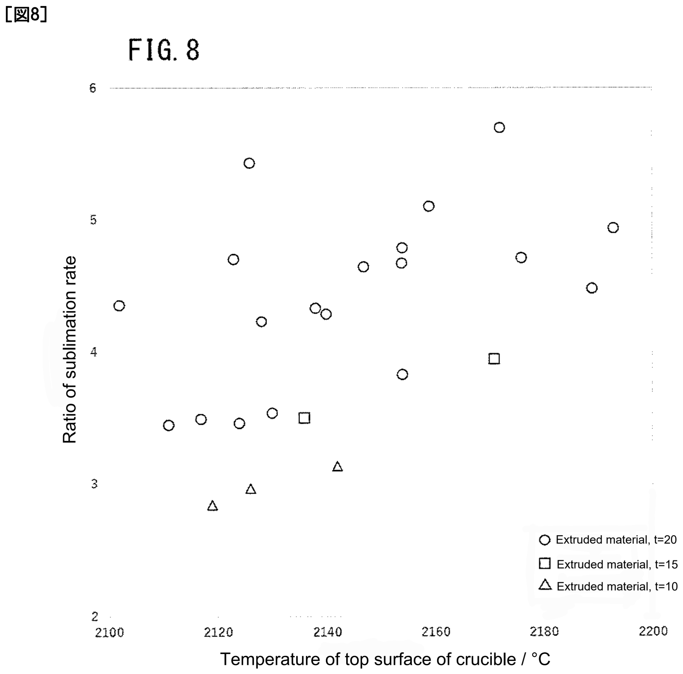

Furthermore, as shown in FIG. 8, a look at tendencies relating to the thickness of the side wall of a crucible reveals a tendency that the thicker the side wall, the higher the sublimation rate. It can be understood that this is because a crucible with a thicker side wall increases the amount of heat transferred upward through the side wall of the crucible, resulting in a larger amount of heat transferred to the source material via the side surface of the crucible.

It was expected that, if a crucible with a thicker side wall was used, this also would increase the amount of heat transferred to the lid of the crucible via the side wall of the crucible, which would increase the temperature of the seed crystal held on the lid and the surface of the growing crystal, resulting in a decrease in the temperature difference between the source material and the surface of the growing crystal, decreasing the sublimation rate; however, this was not observed under the present test conditions. It can be understood that this is because the amount of heat transferred to the source material via the side wall of the crucible was sufficiently large compared with the amount of heat transferred to the lid of the crucible through the side wall of the crucible.

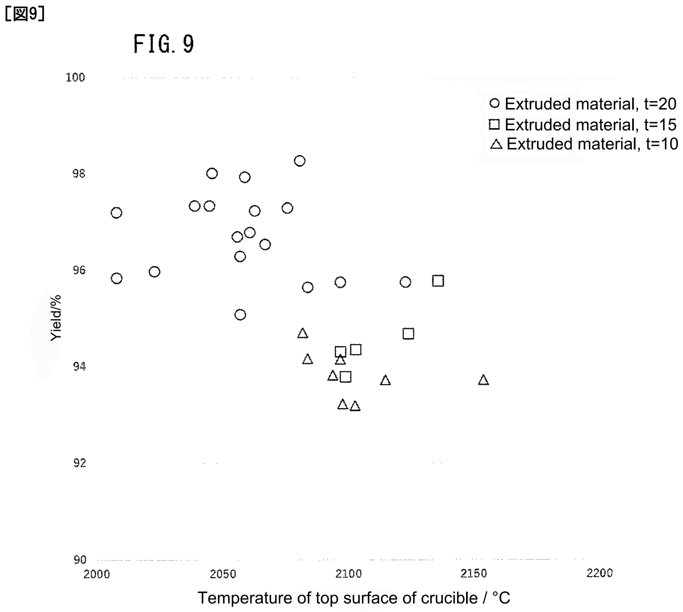

Next, for the extruded-material crucibles with side walls of different thicknesses, the ratio of the entire amount of SiC crystal that had recrystallized on the crucible lid to the amount of the above-mentioned SiC source material that had sublimated (= yield) was obtained and, similar to FIG. 8, the results were plotted in FIG. 9 where the temperature of the top surface of a crucible is indicated by the horizontal axis.

This graph presupposes that the increase in the weight of the lid measured after crystal growth is the entire amount of recrystallized SiC crystal. On portions of the graphite surface of the lid of a crucible where the seed crystal is not present, polycrystalline material is produced during crystal growth, mainly in areas at low temperatures, and grows over time while the single crystal is growing on the seed crystal. In other words, the entire amount of SiC crystal includes the single crystal that has grown on the seed crystal and the polycrystalline material that has grown on other areas of the graphite surface of the lid.

On the other hand, the inside of a graphite material includes micro-to macro-sized pores, which may connect to form through-holes, through which sublimated gas that has been produced within the crucible and is supposed to serve as the source of SiC single crystal growth may leak to the outside of the crucible and fail to contribute to crystal growth, which represents a loss. This loss becomes recognizable as a decrease in the yield that decreases crystal growth rate and, in addition, leads to recrystallization outside the crucible, directly leading to a deterioration of equipment outside the crucible and/or installed components; in view of this, higher yields are preferable.

Tendencies in FIG. 9 clearly demonstrate that the larger the wall thickness of the side wall of a crucible, the higher the yield. This result can easily be understood to be a result of a thicker wall restricting transportation of sublimated gas to the outside of the crucible through the through-holes present within the side wall of the crucible (the thicker wall meaning a longer distance of the through-holes and/or fewer through-holes for passage).

When the same tests were conducted using a typical CIP material, the yield was not lower than 93 %; as such, as long as yield is concerned, the thickness of the side wall of an extruded-material crucible is only required to be equivalent to that for a CIP material to provide a yield equivalent to that for a CIP material. In other words, if the thickness of the side wall of a CIP-material crucible used is 10 mm, the thickness of the side wall of an extruded-material crucible required to provide an equivalent yield is assumed to be about 10 mm. On the other hand, larger thicknesses decrease the loading capacity for source material compared with a crucible with the same outer diameter, which significantly decreases production efficiency.

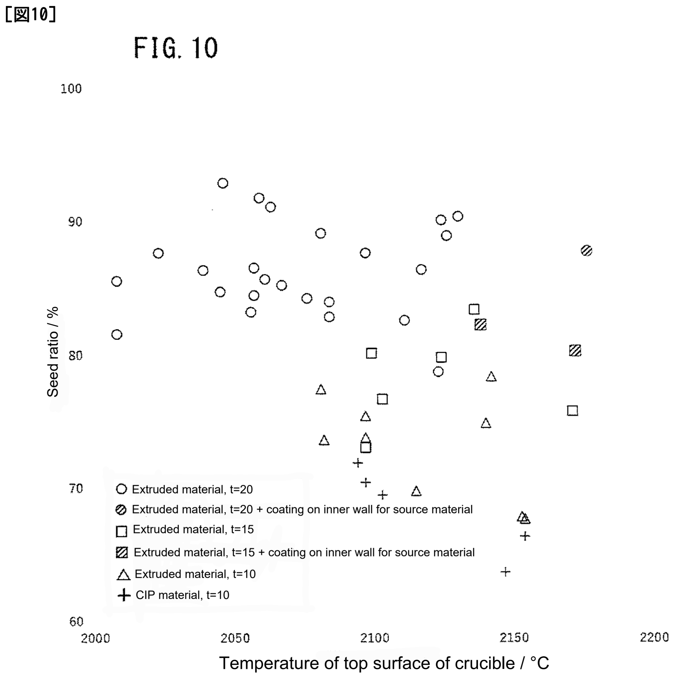

Next, for each of the above-described crucibles, the ratio of SiC crystal that grew in the form of a single crystal on the SiC seed crystal to the total amount of crystal that grew on the lid (= seed ratio) was obtained and, similar to the above, the results were plotted in FIG. 10 where the temperature of the top surface of the crucible is indicated by the horizontal axis. In this graph, the amount of a grown crystal was calculated from the volume of the SiC single crystal calculated by a 3D measurement device and the SiC single crystal density. If the above-discussed ratio of grown polycrystalline material is high, the growth rate of the single crystal decreases and, in addition, the polycrystalline material reaches the single crystal, which introduces crystal defects and/or leads to crystal cracking during temperature drop; in view of this, higher seed ratios are preferable.

Tendencies in FIG. 10 show that, across the entire range of the temperature of the top surface of a crucible from about 2000 to 2200 °C, the use of an extruded-material crucible enhances the seed ratio over a CIP-material crucible. Further, a look at tendencies relating to the thickness of the side wall of the crucible reveals a tendency that the thicker the side wall, the higher the seed ratio. This tendency can be considered to be a result of the use of an extruded-material crucible with better thermal conductivity along the height direction of the crucible increasing the amount of heat toward the lid of the crucible through the side wall of the crucible and heating areas closer to the side wall of the crucible around the seed crystal, reducing the growth of polycrystalline material in these areas, or a result of the increase in the thickness of the side wall of the crucible increasing that effect.

Similarly to the above discussion regarding sublimation rate, it was expected that, as a side effect, an increase in the temperature of a seed crystal held on a lid and the surface of the growing crystal might decrease the driving force for crystal growth and decrease the seed ratio; however, this was not observed under the present test conditions. It can be understood that this is a result of the thermal conductivity along the lateral direction of an extruded-material crucible (i.e., direction perpendicular to the direction of extrusion) being not as high as that for the vertical direction (i.e., direction parallel to extrusion), preventing heat from the side wall of the crucible from reaching the location at which the seed crystal is held.

This, together with the effect of increasing the sublimation rate in FIG. 7, allows one to readily assume that crystal growth rate will be higher if an extruded-material crucible is used. Although not shown, a comparison with a CIP material under the conditions of the present tests demonstrates that crystal growth rate (= volume of SiC single crystal calculated by above-mentioned 3D measurement device ÷ cross-sectional area of seed crystal) is higher by about 24 %.

Further, the results of tests where, in a crucible, the inner wall of its portion that is loaded with source material is covered with a flexible graphite sheet are shown in FIG. 10. This sheet has a strong anisotropy of thermal conduction and, when covering the inner wall, works as a "weak insulator" that prevents supply of heat from the side wall of the crucible to the source material. As a result, while the sublimation rate decreased by about 20 %, the seed ratio improved, similar to a crucible with a thick wall. It can be understood that this is because heat supplied to the source material is reduced for the reasons stated above, resulting in areas closer to the side wall of the crucible around the seed crystal being heated, reducing growth of polycrystalline material produced in these areas, which is the same effect as produced by the increase in the thickness of the side wall of a crucible.

According to the above-described embodiments, the material of a crucible used is mainly an extruded material; alternatively, a CIP material may be used. Further, both an extruded material and a CIP material may be used. For example, the lid of a crucible (or the seat that allows an SiC seed crystal to be mounted thereon) may be made of a CIP material, while the bottom and side wall of the crucible may be made of an extruded material.

Furthermore, the crucible may be made of the same kind of graphite; alternatively, the crucible may be made of different kinds of graphite. For example, to reduce stress applied to the SiC single crystal growing on the lid, the lid may be made of a graphite that has the same coefficient of thermal expansion as the SiC single crystal or a coefficient of thermal expansion close thereto. A graphite with such a coefficient of thermal expansion may be amorphous coke, for example.

Although embodiments of the present invention have been described, the present invention is not limited to the above-described embodiments, and variations are possible within the scope of the claims.

### REFERENCE SIGNS LIST

- 10:: crucible
- 20:: source material
- 26:: SiC single crystal
- 31:: kneaded material
- 35:: columnar body
- 40:: coke
- 120:: bottom
- 122:: side wall
- LT:: lateral thermal conductivity
- VT:: vertical thermal conductivity
- φL:: large diameter
- φS:: small diameter

## Claims

1. A crucible to be used to manufacture an SiC single crystal by a sublimation method, comprising:
a bottom;
a side wall provided to extend upward from a peripheral edge of the bottom; and
a lid placed over a top of the side wall,
wherein:
the bottom, the side wall, and the lid are formed from a graphite;
the crucible has a vertical thermal conductivity along a vertical direction in which the side wall extends, and a lateral thermal conductivity along a lateral direction perpendicular to the vertical direction; and
the vertical thermal conductivity is higher than the lateral thermal conductivity.

2. The crucible according to claim 1, wherein the graphite is formed from an extruded material.

3. A method of manufacturing a crucible to be used to manufacture an SiC single crystal by a sublimation method, the method comprising:
preparing a material;
kneading the material together with a binder pitch to prepare a kneaded material;
extruding the kneaded material to form a columnar body;
heating the columnar body for graphitization; and
processing the graphitized columnar body to form the crucible,
wherein:
the crucible includes:
a bottom;
a side wall provided to extend upward from a peripheral edge of the bottom; and
a lid placed over a top of the side wall,
the bottom, the side wall, and the lid are formed from a graphite; and
a vertical direction in which the side wall extends is identical with a direction in which the kneaded material is extruded.

4. The method of manufacturing a crucible according to claim 3, wherein the material includes a piece of coke with an aspect ratio of a large diameter to a small diameter not lower than 1.1.

5. The method of manufacturing a crucible according to claim 3, wherein:
the crucible has a vertical thermal conductivity along a vertical direction in which the side wall extends and a lateral conductivity along a lateral direction perpendicular to the vertical direction; and
the vertical thermal conductivity is higher than the lateral thermal conductivity.
